# EUROPEAN PATENT APPLICATION

(11) **EP 4 506 484 A1**
(43) Date of publication of application: **12.02.2025**
(21) Application number: 22936458.3
(22) Date of filing: 04.04.2022
(51) Int. Cl.: C23C 14/24, C23C 14/32

(54) **FILM-FORMING DEVICE**

(71) Applicant: National University Corporation Toyohashi University of Technology, Tempaku-cho, Toyohashi-shi, Aichi 441-8580 (JP); OSG Corporation, Aichi 442-0005 (JP)
(72) Inventor: TAKIKAWA, Hirofumi, Toyohashi-shi, Aichi 441-8580 (JP); BANDO, Takahiro, Toyohashi-shi, Aichi 441-8580 (JP); SAIKI, Yoshinori, Toyohashi-shi, Aichi 441-8580 (JP); KITO, Jumpei, Toyohashi-shi, Aichi 441-8580 (JP); HASHIMOTO, Yuki, Toyohashi-shi, Aichi 441-8580 (JP); SUGITA, Hiroaki, Toyokawa-shi, Aichi 441-1231 (JP); GIMA, Hiroki, Toyokawa-shi, Aichi 441-1231 (JP)
(74) Representative: Kuhnen & Wacker Patent- und Rechtsanwaltsbüro PartG mbB
(86) International application number: PCT/JP2022/017073
(87) International publication number: WO 2023/195058

(57) **Abstract**

[Problem] To provide a film-forming device capable of reducing attachment of particles emitted from a cathode to a magnet field generator and capable of efficiently forming a vapor deposited film with few droplets, which are by-product particles emitted from the cathode, by arranging an anode part with a function of producing a magnetic field between a cathode part and an object to be treated. [Solution] A film-forming device forms a film by vapor deposition on a surface of an object to be treated by vaporizing a cathode material constituting a cathode by plasma generating means which generates plasma by an arc discharge. The plasma generating means comprises a cathode part, an anode part arranged at an appropriate distance from the cathode part, a magnetic field generator and a protection member. The magnet field generator is constituted by the anode part or constituted integrally with or continuously from the anode part and generates a magnetic field by an electric current of the arc discharge. The protection member is constituted by part of the anode part, or constituted independently from the anode part while electrically connected to the anode part, and arranged outside a plasma flow region and protects part or a whole of the magnetic field generator from attachment of the cathode material.

## Description

### Technical Field

The present invention relates to a film-forming device, and particularly to a device which generates plasma by an arc discharge in a vacuum (e.g., 0.0001-50 Pa) to vaporize a cathode material and forms a film by vapor deposition on a surface of an object to be treated.

### Background Art

It is widely known to improve surface properties of a solid material (an object to be treated) by generating plasma and forming a thin film or implanting ions on a surface of the solid material (the object to be treated). A film formed by using plasma containing metal ions and/or non-metal ions is useful as a protection film because the film increases abrasion and corrosion resistance of a surface of a solid material. As is also known, especially a carbon film formed by using carbon plasma is highly useful as a diamond-like carbon film (a DLC film) comprising an amorphous mixture of the diamond structure and the graphite structure. As is also known, a metal nitride film such as a titanium nitride film and a titanium aluminum nitride film formed by introducing nitrogen gas into an atmosphere and vaporizing a metal such as titanium (Ti) or an alloy such as titanium aluminum (TiAl) can be used for a variety of applications, e.g., as protective coatings for tools and component parts and as decorative coatings for component members. These types of techniques are referred to as vacuum arc vapor deposition, arc ion plating, arc PVD, cathodic arc vapor deposition, etc. Although typical vacuum arc vapor deposition devices often employ a vacuum chamber serving as an anode, an anode in the present invention is independent of a vacuum chamber and arranged in a vacuum chamber.

By the way, plasma containing metal ions and/or non-metal ions is generated by a vacuum arc discharge. The vacuum arc discharge occurs between a cathode and an anode. On a surface of the cathode, there are high-temperature cathode spots where the vacuum arc discharge starts, and a cathode material evaporates from the cathode spots and the evaporated cathode material forms vacuum arc plasma. When any one or more of a reactive gas (nitrogen, oxygen, hydrogen, hydrocarbons, fluorine, silicon, etc.) and an inert gas (noble gas) are introduced as an atmosphere gas, these gases are simultaneously ionized. By using such plasma, surface treatment such as thin film formation and ion implantation is applied to a surface of a solid material. Liquid containing a material to be reacted can be vaporized and introduced to a process chamber.

In a plasma-generating vacuum arc discharge as mentioned above, constituent particles such as electrons and evaporated cathode material particles (atoms (or molecules)) are emitted from cathode spots. Simultaneously, submicron to several hundreds of microns (0.01-1,000 µm) of droplets (also referred to as macroparticles) are also emitted from the cathode spots as by-product particles. At this time, the electrons emitted from the cathode spots collide with the evaporated cathode material particles and these particles are ionized into metal ions and/or non-metal ions. The evaporated cathode material particles collide with the electrons and get ionized mostly immediately after emitted from the cathode spots (in a very close range from a surface of a cathode to about several millimeters from the surface). Unionized evaporated cathode material particles (except those to be ionized later), introduced gas particles (molecules or atoms), reacted particles (molecules), etc. are neutral particles (hereinafter sometimes collectively and simply referred to as neutral particles) and move straight in original emitted directions as particles which are not affected by a magnetic field or an electric field. On the other hand, droplets (by-product fine particles) are emitted by explosive boiling at a cathode part. Having no charge, the droplets also move straight without affected by a magnetic field or an electric field. In surface treatment of a solid material, however, attachment of the droplets (by-product fine particles) onto a substrate surface causes a problem. That is to say, if the droplets (by-product fine particles) are attached onto the surface of the solid material, the surface becomes uneven, so a thin film lacks uniformity and a resultant product is sometimes regarded as a low-quality or defected product.

In order to avoid attachment of the droplets (by-product fine particles), part of the present inventors proposed a plasma generating device in which a flow of plasma emitted from a plasma generator (a flow of vacuum arc plasma generated at cathode spots and moving toward an anode and/or an object to be treated; hereinafter sometimes referred to as a plasma flow) is guided in a direction not to face the plasma generator by being bent by a curved magnetic field, and at the same time by-product fine particles are guided to face the plasma generator, thereby separating the plasma flow from the droplets (by-product fine particles) (See PTL 1).

### Citation List

### Patent Literature

[PTL 1] JP2002-008893A
[PTL 2] JP2005-216575A

### Non-Patent Literature

[NPL 1] Andre Anders, "Approaches to rid cathodic arc plasmas of macro- and nanoparticles: a review", Surface and Coatings Technology, 120-121 (1999) pp.319-330

### Summary of Invention

### Technical Problem

The technique disclosed in PTL 1 employs a roughly T-shaped branch structure so as to move droplets (by-product fine particles) straight and bend a plasma flow into a perpendicular direction. Owing to the branch structure, the droplets (by-product fine particles) are separated from the plasma flow and only the plasma flow can reach a solid material. The droplets (by-product fine particles) emitted from a plasma generator, however, sometimes collide with side walls of a plasma path along which plasma moves, and some droplets (by-product fine particles) are reflected by the collision and enter the plasma flow. The droplets (by-product fine particles) which have entered the plasma flow are attached to a surface of the solid material after all and harm smoothness of the surface.

Under these circumstances, part of the present inventors invented a structure in which a restriction plate for restricting a flow of droplets (by-product fine particles) and an oblique wall for reflecting droplets (by-product fine particles) which have passed the restriction plate are arranged inside a plasma path (See PTL 2). In this structure, the restriction plate arranged near a plasma generator restricts a flow direction of the droplets (by-product fine particles), the oblique wall reflects droplets (by-product fine particles) which have passed the restriction plate and move in a predetermined direction, and a collector arranged in a desired position collects the droplets (by-product fine particles). This structure prevents the droplets (by-product fine particles) from mixing in the plasma flow.

However, when the plasma flow is bent by such a curved magnetic field as mentioned above, a distance from the plasma generator (a cathode part) to the solid material (the object to be treated) need to be 500 mm or more and is generally set within the range of about from 500 mm to 1,000 mm. The reason for the range is that bending of the plasma flow requires to secure a space in which the plasma flow can move and at the same time arrange a plurality of magnetic field generators, and as a result increases plasma flow path length. There is also a structure in which a plasma flow path serving also as a magnetic field generating coil is given an S shape (See NPL 1). In this case, too, substantial path length of the plasma flow is great after all. However, when a distance from a plasma generator (a cathode part) to a solid material (an object to be treated) is long, an evaporated material formed by an arc discharge is decreased in density (flux) and a film-forming rate is limited. Therefore, in order to improve the film-forming rate, a distance between the plasma generator (the cathode part) and the solid material (the object to be treated) need to be decreased.

Moreover, when the plasma flow path is given an S shape and plasma follows the path to reach a facing solid material (an object to be treated), thereby decreasing plasma flow path length, droplets (by-product fine particles) separated from the plasma flow move straight unlike the plasma flow curved in the S shape. However, since the magnetic field generating coil is curved in order to render an S shape to the plasma path, gaps are generated at curved parts of the magnetic field generator and some droplets (by-product fine particles) move toward the facing solid material (the object to be treated) through these gaps and as a result, can be attached to the solid material (the object to be treated). Moreover, when the plasma flow path is formed by the magnetic field generator, particles emitted from a cathode are sometimes attached to the magnetic field generator in itself. Since the coiled magnetic field generator has a complicated shape, it is extremely troublesome to remove the attached particles of (or clean) the coiled magnetic field generator.

The present invention has been made in view of the foregoing aspects. It is an object of the present invention to provide a film-forming device capable of decreasing attachment of by-product fine particles onto an object to be treated, decreasing attachment of particles emitted from a cathode (including a product reacted with gas which has been introduced into an atmosphere) to a magnetic field generator, and forming a film by vapor deposition efficiently.

### Solution to Problem

A first structure of the present invention is a film-forming device, comprising plasma generating means for generating plasma by an arc discharge in vacuum between a cathode and an anode electrically connected to each other by way of a power source, and vaporizing a cathode material constituting the cathode and forming a film by vapor deposition on a surface of an object to be treated, the plasma generating means comprising a cathode part; an anode part arranged at an appropriate distance from the cathode part; a magnetic field generator constituted by the anode part or constituted integrally with or continuously from the anode part and generating a magnetic field by a self current of the arc discharge; and a protection member constituted by part of the anode part, or constituted independently from the anode part while electrically connected to the anode part, or substituted by part of the magnetic field generator, and arranged between the magnetic field generator and the plasma to protect part or a whole of the magnetic field generator from the cathode material.

According to the above structure, a magnetic field generator generates a magnetic field by an anode part (an anode part or a member constituted integrally with or continuously from the anode part) constituting plasma generating means by using an electric current of an arc discharge. Thus, the magnetic field generator can generate a magnetic field for guiding a plasma flow at a very close position to the plasma generating means. A protection member is arranged on an outside of the plasma flow guided by the magnetic field generator. Since the protection member is arranged between the cathode part and the magnetic field generator, the protection member can protect the magnetic field generator from particles emitted from the cathode (hereinafter sometimes referred to as emitted materials). Protection means to guard the magnetic field generator against attachment of the emitted materials. The emitted materials include not only electrons but also neutral particles (evaporated materials) having no electric charge and droplets (by-product fine particles). Part of the neutral particles, which are evaporated materials, are ionized by collision with the electrons. Charged particles such as electrons and ions are guided toward an object to be treated by a magnetic field generated by the magnetic field generator, but neutral particles and droplets are not affected by the magnetic field and move straight in radially emitted directions. Therefore, when a selected cathode material generates attachable droplets, the magnetic field generator can be protected by attaching the droplets together with the neutral particles to the protection member. Of course, some ions which have not been controlled by the magnetic field are also attached to the protection member, but this description will be omitted hereinafter. When droplets are unattachable (including having a difficulty in being attached, the same applies hereinafter), the magnetic field generator can be protected by making the droplets collide with the protection member, and the magnetic field generator can also be protected by attaching the neutral particles to the protection member. Note that since the droplets are unattachable (difficult to be attached), even if the degree of protection is insufficient, the magnetic field generator is not badly affected by the droplets. Bouncing back (reflecting) the droplets by the protection member after collision mainly aims to hinder the droplets from moving toward an object to be treated. That is to say, the number of droplets reaching the object to be treated can be decreased by controlling the droplets after reflection not to move toward the object to be treated by adjusting a reflection surface of the protection member. Here, droplets which move toward the object to be treated originally from the time of emission from the cathode may be attached to a surface of the object to be treated, but, if the number of droplets thus attached is accepted, the number of droplets attached is decreased when compared to those when no preventive measure is taken. Besides, not only highly energetic ions but also neutral particles reach a surface of the object to be treated, and this contributes to effective film formation by vapor deposition.

A second structure of the present invention is that in the first structure, the magnetic field generator is arranged in a roughly tubular shape surrounding a plasma flow region, and the protection member is a water-cooling ring member arranged at at least one of ends on a cathode side or its opposite side of the roughly tubular magnetic field generator, and having a surface with an appropriate area in a radial direction of the magnetic field generator and having a hollow inner part for introducing cooling water.

According to the above structure, the magnetic field generator has a roughly tubular shape and guides the plasma to flow on its inner side. Besides, a protection member having a ring shape (not necessarily a perfect circle and including a circle with a notch, preferably having a plane with an appropriate width in an approximately perpendicular direction to a plasma flow direction, of course a curved surface is all right, hereinafter this description will be omitted.) is arranged at one or both ends on a cathode side or its opposite side of the magnetic field generator. Therefore, the magnetic field generator can be protected by attaching the evaporated particles (these evaporated particles mean particles to be vapor deposits including a reacted product with introduced gas. This description will be omitted hereinafter.) and the droplets to this protection member or attaching the evaporated particles to the protection member while reflecting the droplets by the protection member. Upon arranged basically at an end on a cathode part side, the protection member can allow evaporated particles (neutral particles evaporated from a cathode and ionized particles after evaporated) and droplets to be attached to (or reflected by) itself before reaching the magnetic field generator. Besides, upon arranged at an opposite side to the above, another protection member can decrease the number of droplets reaching the object to be treated by attaching or reflecting droplets moving toward the object to be treated. At this time, the protection member upon electrically connected to the anode serves as part of the anode and serves as part of plasma generating means. A rise in temperature of the anode can be decreased by introducing cooling water to a hollow inner part. Note that "a roughly tubular shape" is assumed to be a shape of a coiled wire of an electromagnetic coil and means a concept including not only a shape of a circumferentially continuous coil but a shape of an electrically connected assembly of circumferentially discontinuous members.

A third structure of the present invention is that in the first structure, the magnetic field generator is formed in a roughly tubular shape surrounding a plasma flow region, and the protection member is a tubular member arranged between the plasma flow region and the magnetic field generator.

In the above structure, the protection member in a tubular shape is arranged inside the magnetic field generator in a roughly tubular shape. Therefore, the magnetic field generator is protected from a cathode material contained in the plasma flow by the protection member. At this time, upon electrically connected to the magnetic field generator, the tubular protection member substantially serves as the anode of the plasma generating means.

A fourth structure of the present invention is that in the third structure, the protection member has a plurality of through holes.

When droplets which are not attachable to the protection member are generated, the above structure can prevent the droplets from bounced back (reflected) by the protection member and allow the droplets to pass through the through holes. Since the droplets are thrown outside the plasma flow region, the number of droplets at least reaching the object to be treated can be decreased. Since an area except the through holes receives attachment of evaporated particles (including neutral particles, ions, and reacted particles with introduced gas), the protective member can decrease the number of evaporated particles attached to the magnetic field generator.

A fifth structure of the present invention is that in the third structure, at least an inner surface of the protection member is uneven.

The protection member having the above structure decreases the number of droplets bouncing back toward the object to be treated by reflecting the droplets diffusely instead of passing the droplets through the through holes. That is to say, the inner surface of the protection member which is made not even but bumpy by intentional processing changes a bouncing back angle (a reflection angle) of the droplets and decreases the number of droplets moving toward the object to be treated. On the other hand, since evaporated materials are attached to the surface without bounced back, the protection member can protect the magnetic field generator.

A sixth structure of the present invention is concrete embodiments of the fifth structure in which the inner surface of the protection member has a shape selected from a large number of standing parts formed by making a plurality of partial cuts in the protection member and bending parts of the protection member to stand, a large number of through holes formed by perforating appropriate parts of the protection member, a plurality of dents formed by denting the inner surface for an appropriate interval, a large number of projections formed by projecting the inner surface for an appropriate interval, and a plurality of annular projections continuously projecting in a circumferential direction of the roughly tubular shape.

The above structure shows concrete examples of the uneven inner surface of the protection member. When a large number of standing parts are formed by making a plurality of partial cuts in the protection member and bending parts of the protection member to stand, droplets collide with the standing parts formed by bending and are suppressed from bouncing forward. When a large number of through holes are formed by perforating appropriate parts of the protection member, droplets can not only pass through the through holes but also be deviated from moving toward the object to be treated by the bouncing back directions when colliding with inner circumferential parts of the through holes. When a plurality of dents are formed by denting the inner surface for an appropriate interval, or a large number of projections are formed by projecting the inner surface for an appropriate interval, droplets are made to collide with these dents or projections, thereby changing bouncing back directions and decreasing the number of droplets moving toward the object to be treated. These dents or projections can be formed either regularly or irregularly and, when the projections are formed, the projections can be a plurality of annular projections projecting continuously in a circumferential direction of the roughly tubular shape. It should be noted that since evaporated particles are attached to the protection member in any of the aforementioned shapes, this structure contributes to protection of the magnetic field generator. As a matter of course, these surface shapes or holes of the protection member are formed in a manner not to hinder attached materials from easily removed from the protection member (or not to hinder the protection member from easily cleaned) or not to hinder its protection role from deteriorating even after cleaning.

A seventh structure of the present invention is that in each of the above structures, the magnetic field generator is a coiled magnetic field generator constituted by a continuously and spirally winding conductive material or a continuously and spirally winding hollow conductive material.

According to the above structure, the magnetic field generator generates a magnetic field by serving as part of the anode of the plasma generating means or electrically connected to the protection member and spirally applying an electric current for generating an arc discharge. The magnetic field generated by this coiled magnetic field generator guides the plasma flow in a determined direction on its inner side.

When the coiled magnetic field generator is constituted by a hollow conductive material, cooling water can be introduced in the hollow inner part. The introduced cooling water can lower a rise in temperature of the magnetic field generator serving as the anode.

An eighth structure of the present invention is that in any of the above first to sixth structures, the magnetic field generator comprises a plurality of electrically conductive plate members arranged at appropriate intervals, and each of the plate members has a roughly horse-shoe shape in which part of a ring has a notch, and an end on one side of a notch of any one of the plate members is electrically connected with an end on the other side of a notch of an adjacent one to the one of the plate members so that an electric current of an arc discharge flows sequentially between each adjacent two of the plate members in a manner to flow in a roughly spiral shape.

According to the above structure, the magnetic field generator is a plurality of roughly horse-shoe-shaped plate members each arranged in a ring shape. An electric current can be passed in the plurality of plate members in the same circumferential direction by sequentially electrically connecting ends of notches of the roughly horse-shoe-shaped plate members. Upon passing an electric current in a roughly spiral shape, the plate members can generate a magnetic field. At this time, each of the plate members is arranged in a ring shape with respect to a plasma flow formed on an inner side. Therefore, surfaces of the plate members become surfaces to attach evaporated particles on and can also serve as surfaces to attach droplets on or reflect droplets by. That is to say, some plate members located on a cathode side serve as the protection member and can protect the other plate members (part of the magnetic field generator) located after these plate members. Note that all the plate members do not have to be the same size and some of them can have a smaller inner diameter. When the plasma flow is bent while transported as mentioned above and some plate members near the bent part have a smaller inner diameter than other plate members, magnetic flux density of the bent part can be increased and loss of ions to be transported can be decreased. Moreover, when a protection member is provided, the protection member suppresses attachment of the evaporated particles and attachment or collision of the droplets to the plate members. At this time, evaporated particles and droplets which move past the protection member can be attached to (or reflected by) the plate members, thereby decreasing at least the number of droplets reaching the object to be treated.

A ninth structure of the present invention is that in the eighth structure, the plate members are arranged so that center positions of the roughly horse-shoe shapes are sequentially displaced in an angular direction with respect to a plasma flow direction, thereby making the central holes of the magnetic field generator meander.

With this structure, since the central holes of the magnetic field generator meander, the plasma flow meanders in accordance with the shape of the magnetic field generator. Surfaces of the plate members project with respect to a direction from the cathode part toward the object to be treated and serve as surfaces to attach the evaporated particles on and surfaces to attach droplets on or reflect the droplets by. If the degree of meandering is great, any of the plate members is arranged in a straight line from the evaporated particles and droplets to the object to be treated and as a result, hinders at least droplets from reaching the object to be treated.

A tenth structure of the present invention is that in the ninth structure, the magnetic field generator has a water-cooling ring member in a hollow annular shape at a given position from a starting end side to a finishing end side of the plate members. When the plate members serve as the anode of the plasma generating means, this structure can reduce a rise in temperature of the plate members.

Preferably, the magnetic field generator in each of the aforementioned structures of the present invention generates a magnetic field having a magnetic flux density within the range of 0.01 to 20 mT. Upon controlling the magnetic flux density within the appropriate range, the magnetic field can properly guide a plasma flow direction.

### Advantageous Effects of Invention

According to the present invention, the magnetic field generator for guiding the plasma flow generates a magnetic field by an electric current for generating an arc discharge by the plasma generating means. Therefore, a distance which plasma is guided to travel can be decreased. In the short distance, droplets are attached to the protection member or a direction in which the droplets is bounced back by a surface of the protection member is controlled and thereby the droplets are suppressed from reaching the object to be treated. Moreover, upon attached to the protection member, the evaporated particles (and droplets to be attached) can be suppressed from attached to the magnetic field generator in itself and necessity of an operation to remove the attached materials of (or clean) the magnetic field generator can be reduced. Besides, since part of the neutral particles in addition to high energy ions reach the object to be treated, film formation can be performed with high efficiency.

### Brief Description of Drawings

[Fig. 1] Fig. 1 is an explanatory schematic diagram showing an entire film-forming device.
[Fig. 2] Fig. 2 is an explanatory diagram showing details of a first embodiment.
[Figs. 3] Fig. 3(a) is an explanatory diagram showing a second embodiment. Fig. 3(b) shows its modification.
[Figs. 4] Figs. 4(a) and 4(b) are explanatory diagrams showing other modifications of the second embodiment.
[Figs. 5] Figs. 5(a) and 5(b) are explanatory diagrams showing details of a magnetic field generator of a third embodiment.
[Figs. 6] Figs. 6(a) and 6(b) are explanatory diagrams showing how to use the third embodiment.
[Figs. 7] Figs. 7(a) and 7(b) are explanatory diagrams showing details of a fourth embodiment.
[Figs. 8] Figs. 8(a) and 8(b) are scanning electron microscopy images of an experiment result and a comparative experiment result.
[Figs. 9] Figs. 9(a) and 9(b) are explanatory diagrams of a modification of the first embodiment.
[Figs. 10] Figs. 10(a) and 10(b) are explanatory diagrams of another modification of the first embodiment.
[Figs. 11] Figs. 11(a) and 11(b) are explanatory diagrams of still other modifications of the first embodiment.

### Description of Embodiments

Hereinafter, embodiments of the present invention will be described with reference to the drawings. First, an overview of an entire structure of a film-forming device will be described and then details will follow.

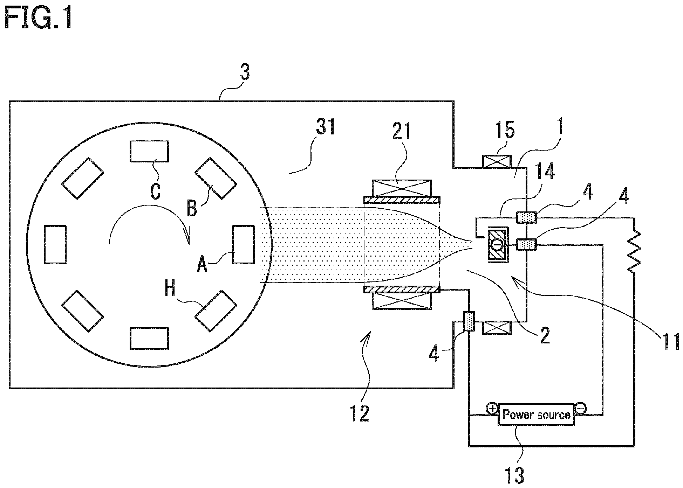

Fig. 1 is a schematic diagram of a film-forming device. A film-forming device according to the present invention roughly comprises plasma generating means 1, a plasma duct 2 which is a transport route of evaporated particles formed by vaporizing a cathode material by the plasma generating means, and a film-forming chamber 3 for forming a film. The plasma generating means 1 includes a cathode part 11 and an anode part 12 arranged near the cathode part 11. The cathode part 11 and the anode part 12 are respectively connected to an external arc power source 13 by way of insulated feed-through terminals 4, thereby enabling an arc discharge.

The cathode part 11 includes a cathode 11A formed of a film-forming material, and this cathode 11A corresponds to a target (a raw material of evaporated materials). Although the cathode 11A serves also as a target in embodiments of the present invention, a film-forming material to be a target can be separately arranged on a surface of the cathode 11A. A constituent material of the cathode 11A serving also as a target can be any electrically conductive solid such as simple metals, alloys, simple inorganic substances, and inorganic compounds. These materials can be used singly or as a mixture of two or more. For example, simple metals can be all of main group metals and transition metals. Typical examples of simple metals include Al, Ti, V, Cr, Fe, Co, Ni, Cu, Zn, Y, Zr, Nb, Ag, In, Sn, Sb, Hf, Pt, Au, Hg, Pb, Nd, Ta, W, and Mo. Examples of alloys and intermetallic compounds include TiAl, TiCr, TiSi, AlSi, AlCr, and NdFe. An example of simple inorganic substances is C(graphite). Examples of inorganic compounds (ceramics) include oxides such as TiO₂, ZnO, SnO₂, ITO (Indium Tin Oxide: tin-doped indium oxide), In₂O₃, Cd₂SnO₄, and CuO, carbides and nitrides such as TiN, TiAlC, TiC, CrN, and TiCN, and mixtures of two or more of them. Non-metal materials can be mixed in a range in which the cathode 11A keeps its electric conductivity (becomes semiconductive or metalloid), and are exemplified by B, C, Si, P, Ge, As, Se, Sb, Te, Bi, Po, At. Examples of an atmosphere gas include He, Ar, H₂, N₂, O₂, fluoride gas, hydrocarbon gas, chloride gas, sulfide gas and a mixture thereof. Gas or vapor of liquid containing fluorine, hydrogen, carbon, chlorine, sulfur, boron, phosphorus, etc. can be introduced into an atmosphere.

The anode part 12 can be any conductive material which withstands temperature of about 200° C such as simple metals, alloys, simple inorganic substances, and inorganic compounds. The material of the anode part 12 can be appropriately selected from the listed examples of the cathode material. These materials can be used singly or as a mixture of two or more. For example, stainless steel, soft iron, steel, copper, copper alloys, aluminum, aluminum alloys, and graphite can be used as the anode part 12.

A trigger electrode 14 is arranged near the aforementioned cathode 11A, and induces a vacuum arc between the cathode part 11 and the anode part 12. That is to say, when the trigger electrode 14 is temporarily contacted with a surface of the cathode 11A and then separated, an electric spark is generated between the cathode 11A and the trigger electrode 14. When the electric spark occurs, electric resistance decreases between the cathode part 11 and the anode part 12 and a vacuum arc is generated between the cathode part 11 and the anode part 12. An arc-stabilizing magnetic field generator 15 is arranged around the cathode part 11. The arc-stabilizing magnetic field generator 15 serves to stabilize cathode spots of the vacuum arc and plasma generated by the arc discharge. Although located outside the chamber in Fig. 1, the arc-stabilizing magnetic field generator 15 can be located inside the chamber, or behind the cathode part. A plurality of arc-stabilizing magnetic field generators 15 can be arranged. The arc-stabilizing magnetic field generator 15 only need to apply a magnetic field, which stabilizes cathode spots and an arc discharge and efficiently transports a plasma flow, to a surface of the cathode and/or a front of the cathode.

A region to be a transport route of evaporated particles is formed inside the anode part 12 having a roughly tubular shape. Although details will be described later, a magnetic field generator 21 comprising an electromagnet is arranged on an outer periphery of the roughly tubular anode part 12, and generates an induced magnetic field for guiding charged particles formed by evaporation of a film-forming material to move in a predetermined direction. This induced magnetic field is oriented along a central axis of the roughly tubular anode part 12.

The charged particles in the region to be a transport route are guided along the central axis of the roughly tubular anode part 12 in a straight line direction from the cathode part 11. Thus, the charged particles are supplied to an object A to be treated in the film-forming chamber 3 through an opening 31 of the film-forming chamber 3 arranged in front. Since this transport route is straight line, a distance from the cathode part 11 to the object A to be treated can be small.

The film-forming chamber 3 has the opening 31 on a side facing the plasma generating means 1, and also has object-holding means 32 for holding objects A, B, ..., H to be treated on an inside. Upon rotated intermittently, the object-holding means 32 can make the plurality of objects A to H to be treated sequentially face the plasma generating means 1 and be subjected to a film-forming process.

In the vacuum arc discharge for forming plasma, not only electrons and evaporated cathode material particles but also droplets are simultaneously emitted from cathode spots. At this time, the evaporated cathode material particles collide with electrons emitted from the cathode spots, and get ionized into metal ions and/or non-metal ions. The evaporated cathode material particles collide with the electrons and get ionized mostly immediately after emitted from the cathode spots. Unionized evaporated cathode material particles (except those to be ionized later), introduced gas particles, reacted particles, etc. are neutral particles and move straight in original emitted directions without affected by a magnetic field or an electric field. On the other hand, droplets are emitted by explosive boiling at the cathode. Having no electric charge, the droplets also move straight without affected by a magnetic field or an electric field.

### [First Embodiment]

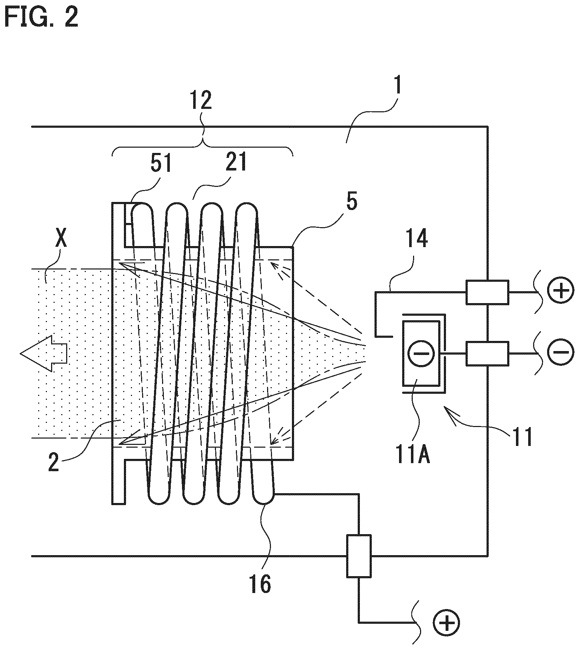

Now, a first embodiment of the present invention will be described. Fig. 2 shows a structure of plasma generating means 1 of the present embodiment. As shown in this drawing, provided on an anode side constituting the plasma generating means 1 are a protection member 5, and an electromagnetic coil (an electric field generator) 21 electrically connected with the protection member 5. The electromagnetic coil 21 is connected to a positive electrode side of an arc power source and enables an arc discharge between the cathode part 11 and the protection member 5.

The protection member 5 has a roughly tubular shape and is formed of an electrically conductive material such as non-magnetic stainless steel, copper or copper alloys. The electromagnetic coil 21 is arranged to wind around the roughly tubular protection member 5. The protection member 5 and the electromagnetic coil 21 are electrically connected to each other at ends on a far side from the cathode part 11 by a connector 51. An end of the electromagnetic coil 21 at a farthest position from the connector 51 is connected to the positive electrode side of the arc powder source. The protection member 5 and the electromagnetic coil 21 both formed of electrically conductive materials are not in contact with each other in order not to electrically connect each other.

When an arc discharge occurs, owing to the abovementioned structure, electrons (indicated by dashed arrows in the drawings. The same applies hereinafter.) emitted from the cathode 11A move to the protection member 5 formed of an electrically conductive material, as indicated by dashed arrows. These electrons further move to the electromagnetic coil 21 by way of the connector 51 and sequentially move along the electromagnetic coil 21 and finally move to the positive electrode side of the arc power source though a power source connector 16. As a result, an electric current flows in the electromagnetic coil 21, which generates a magnetic field.

At this time, an arc discharge occurs between the cathode part 11 and the protection member 5 and arc plasma X is guided by the magnetic field generated by the electromagnetic coil 21 to flow along a central axis of the protection member 5. Therefore, the anode part 12 is constituted by the whole of the protection member 5 and the electromagnetic coil 21, but an anode contributing to generation of an arc discharge is constituted by a local part of the protection member 5. In the present embodiment, the protection member 5 serves as an anode.

Moreover, the protection member 5 serves to protect the electromagnetic coil (magnetic field generator) 21. That is to say, the protection member 5 is arranged inside the electromagnetic coil 21 and arc plasma X flows inside the protection member 5. Thus, the protection member 5 is arranged between the plasma flow and the electromagnetic coil 21. Although evaporated particles and droplets contained in emitted materials are also emitted, unionized particles (neutral particles) and droplets among them are emitted in straight line directions without affected by a magnetic field of the electromagnetic coil 21. Therefore, the unionized particles and the droplets are emitted also at some angles (in directions of the arrows in the drawing) to the central axis of the electromagnetic coil 21 regardless of a plasma flow (a transport route of evaporated particles). The protection member 5 protects the electromagnetic coil 21 from the neutral particles and the droplets thus emitted. As a matter of course, the electromagnetic coil 21 is located outside the protection member 5, so the electromagnetic coil 21 is protected from attachment of evaporated particles (reacted particles with introduced gas) other than neutral particles and ions which are not greatly affected by the magnetic field, etc.

Neutral particles and droplets among cathode emitted materials which have reached an inner surface of the protection member 5 are attached to the inner surface of the protection member 5 just like attached to an object to be treated in forming a film. Therefore, emitted neutral particles and droplets except those moving along the central axis of the electromagnetic coil 21, that is to say, neutral particles and droplets emitted at some angles to the central axis can be removed by attached to the protection member 5. Therefore, the emitted neutral particles and the droplets can be prevented from attached to the magnetic field generator in itself. Moreover, since the droplets are attached to the protection member 5, the number of droplets reaching an object to be treated can be decreased. How to remove droplets generated in forming a DLC film (unattachable droplets) will be mentioned later.

In the structure mentioned above, the entire anode is constituted by the protection member 5 and the electromagnetic coil 21, that is to say, the role of a local anode is played by the protection member 5 and at the same time, a magnetic field is generated by applying an electric current to the electromagnetic coil 21. Therefore, a distance from the cathode part 11 to the object to be treated can be greatly decreased, and this can reduce a decrease in density of the evaporated materials formed by an arc discharge and improve a rate of forming a film.

### [Second Embodiment]

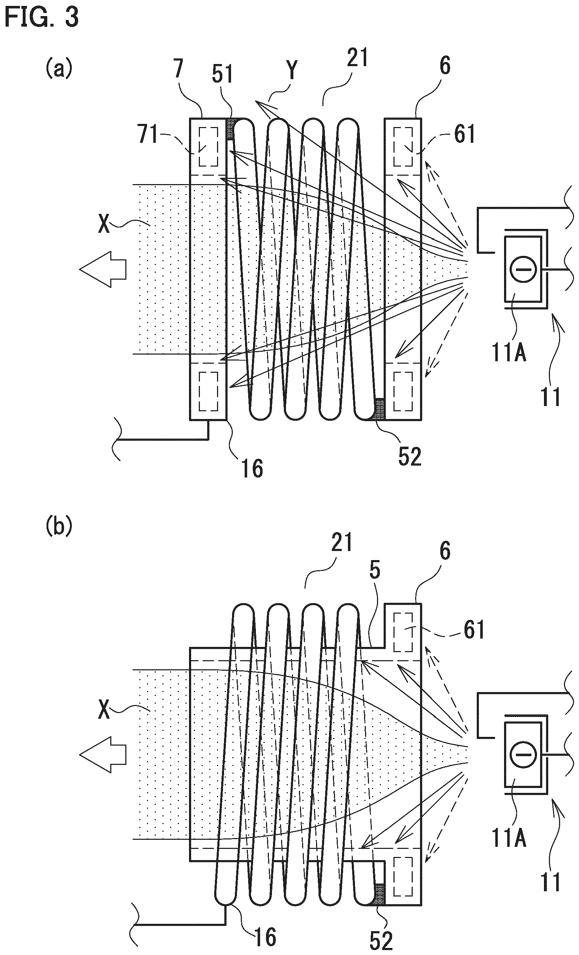

In a second embodiment of the present invention as shown in Fig. 3(a), an annular protection member 6 and a distal end annular member 7 each having an appropriate dimensional difference between an outer diameter and an inner diameter and having a predetermined thickness are arranged at both ends (an end on a cathode part side and an end on its opposite side) of an electromagnetic coil 21. Having such an annular shape as mentioned above, the protection member 6 has a surface having a predetermined area in a radial direction of the electromagnetic coil 21 and a surface having a predetermined area in an inner circumferential direction. The inside of the annular protection member 6 have an inner diameter which arc plasma X barely passes through. The protection member 6 aims to protect the electromagnetic coils 21 by receiving attachment of evaporated particles and droplets and at the same time aims to suppress the droplets from reaching an object to be treated by these two surfaces, and therefore, enlargement of these two surfaces contributes to prevention of the evaporated particles and the droplets from attached to the electromagnetic coil 21.

That is to say, the protection member 6 arranged on a cathode part side has a surface facing the cathode part 11 and an inner circumferential surface which are located on a closer side to the cathode part 11 than the electromagnetic coil 21. Therefore, the evaporated particles and the droplets can be attached to these two surfaces before reaching the electromagnetic coil 21, thereby suppressed from reaching the electromagnetic coil 21.

On the other hand, the distal end annular member 7 located at an opposite side to the cathode part side receives attachment of the evaporated particles and the droplets which have passed the electromagnetic coil 21. Since this distal end annular member 7 also has a surface facing the cathode part 11 and an inner circumferential surface (an inner circumferential surface in particular) and purposefully allows at least droplets to be attached to these surfaces, the distal end annular member 7 inhibits passage of the droplets emitted toward these surfaces and suppresses the droplets from reaching an object to be treated.

In this structure, the protection member 6 and the distal end annular member 7 are formed of electrically conductive materials. When both a connector 52 on the cathode part side between the protection member 6 and the electromagnetic coil 21 and a connector 51 on the opposite side to the cathode part side between the distal end annular member 7 and the electromagnetic coil 21 are formed of electrically conductive materials, the distal end annular member 7 located on the opposite side to the cathode part side can serve as an anode at the time of an arc discharge. In this case, electrons generated at the cathode 11A mainly move to the protection member 6 formed of the electrically conductive material, as shown by the dashed arrows. These electrons further move to the electromagnetic coil 21 by way of the connector 52, and sequentially move along the electromagnetic coil 21. Thus, an electric current flows in the electromagnetic coil 21, which generates a magnetic field. Of course, some electrons reach the electromagnetic coil 21, but these electrons flow in the electromagnetic coil 21 and eventually flows from the distal end annular member 7 to a positive electrode of a power source. When the protection member 6 and the distal end annular member 7 are formed of electrically non-conductive materials or the connectors 51, 52 are formed of electrically non-conductive materials, the electrons generated at the cathode 11A move along the electromagnetic coil 21 from an end on the cathode part side of the electromagnetic coil 21 as a main starting point, and similarly an electric current flows in the electromagnetic coil 21. In this case, connection to the positive electrode of the power source (a power source connector 16) is preferably located at a farthest position from the cathode part 11 of the electromagnetic coil 21.

By the way, in the above structure, some evaporated particles (including reacted particles with introduced gas) and droplets may pass through someplace between the protection member 6 and the distal end annular member 7 (indicated by the arrow Y in Fig. 3(a)). Some of this kind of evaporated particles and droplets are assumed to be attached to part of the electromagnetic coil 21. In order to prevent this, it is assumed to be effective to reduce an inner diameter of the protection member 6 on the cathode part side.

Moreover, when a cathode material is graphite, etc. (a DLC film is to be formed), droplets are not attached to the protection member 6, the distal end annular member 7 or the electromagnetic coil 21 but bounded back (reflected) after collision. The protection member 6 and the distal end annular member 7 can be provided in order to control a transport direction of the droplets so that the droplets do not move toward an object to be treated. That is to say, the protection member 6 and the distal end annular member 7 reflect droplets containing a graphite material and guide the droplets to directions other than toward the object to be treated. At this time, droplets which have not collided with the protection member 6 but have passed through the protection member 6 are reflected by a surface of the electromagnetic coil 21 or are passed through gaps of the electromagnetic coil 21 and eventually guided in directions other than toward the object to be treated. In this case, the protection member 6 on the cathode part side can be omitted, though evaporated particles are attached to the electromagnetic coil 21. In order to prevent the evaporated particles from attached to the electromagnetic coil 21, it is preferable to provide the protection member 6 on the cathode part side.

It should be noted that in the present embodiment, the distal end annular member 7 serving as an anode can have a hollow annular inner part 71, and cooling water can be introduced to the hollow annular inner part 71 to cool the anode side (the distal end annular member 7 can be a water-cooling ring member). This cooling structure helps to avoid a rise in temperature on the anode side at the time of an arc discharge. When the protection member 6 on the cathode part side serves as an anode, the protection member 6 can have a hollow annular inner part 61 and be similarly cooled. As a matter of course, regardless of whether the protection member 6 and the distal end annular member 7 serve as an anode or not, both the protection member 6 and the distal end annular member 7 can have hollow annular inner parts 61, 71, respectively, and be cooled with water.

### [Modification]

The above second embodiment can be modified as follows. As shown in Fig. 3(b), an annular protection member 6 (not necessarily a perfect circle and possibly a circle with a notch) can be continuously connected to one end (maybe both ends) of a roughly tubular protection member 5, and provided with a hollow annular inner part 61, thereby enabling water cooling. In this case, too, the roughly tubular protection member 5 serves as an anode, but its heat can be absorbed by the annular protection member 6 connected to the roughly tubular protection member 5.

As a matter of course, a distal end annular member 7 (See Fig. 3(a)) having a roughly annular shape can be arranged on an opposite side to cool an anode side. Moreover, in order to suppress a rise in temperature of the electromagnetic coil 21, the electromagnetic coil 21 can comprise a hollow member and water can be introduced into its hollow inner part.

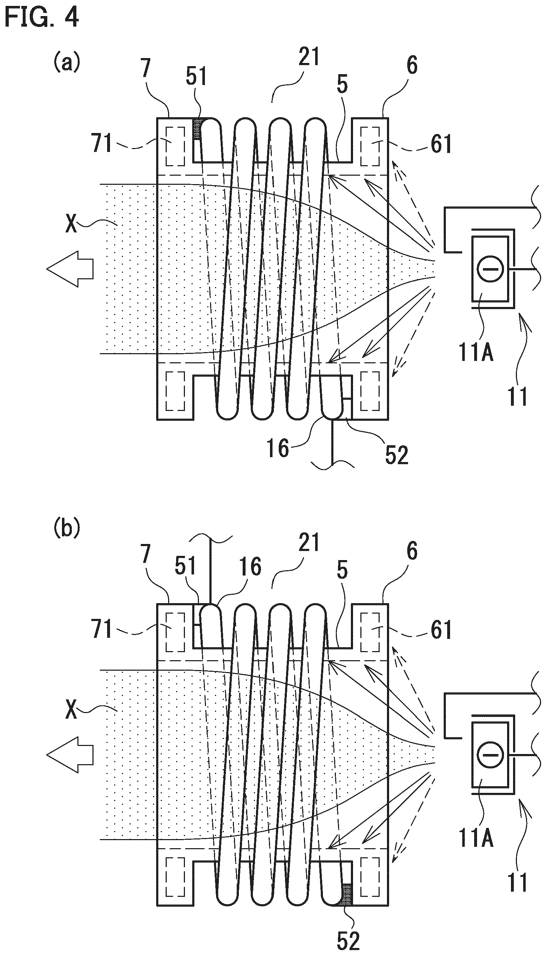

As still another modification as shown in Figs. 4, a roughly tubular protection member 5 is formed integrally with a protection member 6 and a distal end annular member 7 at both ends thereof. "Integrally" means not only a monolithically molded product but also a product formed by physically combining component parts. When employing such an integrally formed product, the roughly tubular protection member 5 and the protection member 6 on a cathode part side can protect an electromagnetic coil 21. As shown in Fig.4(a), when the distal end annular member 7 and the electromagnetic coil 21 are connected by a connector 51 formed of an electrically conductive material and the protection member 6 and the electromagnetic coil 21 are connected by a connector 52 formed of an electrically non-conductive material, electrons generated at a cathode 11A move similarly to those of the first embodiment. That is to say, the electrons move from the distal end annular member 7 to the electromagnetic coil 21 and further move along the electromagnetic coil 21, thereby enabling an electric current (an electron current of a vacuum arc discharge) to flow. In this case, a region including the electromagnetic coil 21 serves as an anode. At this time, connection to a positive electrode of an electric power source (a power source connector 16) is located at part of the electromagnetic coil 21 close to a cathode. Reversely, as shown in Fig.4(b), when the connector 52 of the protection member 6 is formed of an electrically conductive material and the connector 51 of the distal end annular member 7 on an opposite side is formed of an electrically non-conductive material, an electric current (an electron current) flows in an opposite direction and a distal end side of the electromagnetic coil 21 farther away from the cathode part 11 serves as a power source connector 16.

According to the present embodiment, an anode side contributes to an arc discharge, and at the same time a rise in temperature of the anode (especially the protection member 6) by the arc discharge can be reduced. This contributes to efficient generation of arc plasma.

### [Third Embodiment]

A third embodiment according to the present invention is a magnetic field generator comprising plate members assembled in a roughly spiral shape instead of the aforementioned electromagnetic coil 21. That is to say, although the electromagnetic coil 21 is formed of an electrically conductive material in a coil (spiral) shape, a roughly spiral shape is formed by placing a plurality of electrically conductive plate members in parallel and sequentially connecting these members by an electrically conductive material.

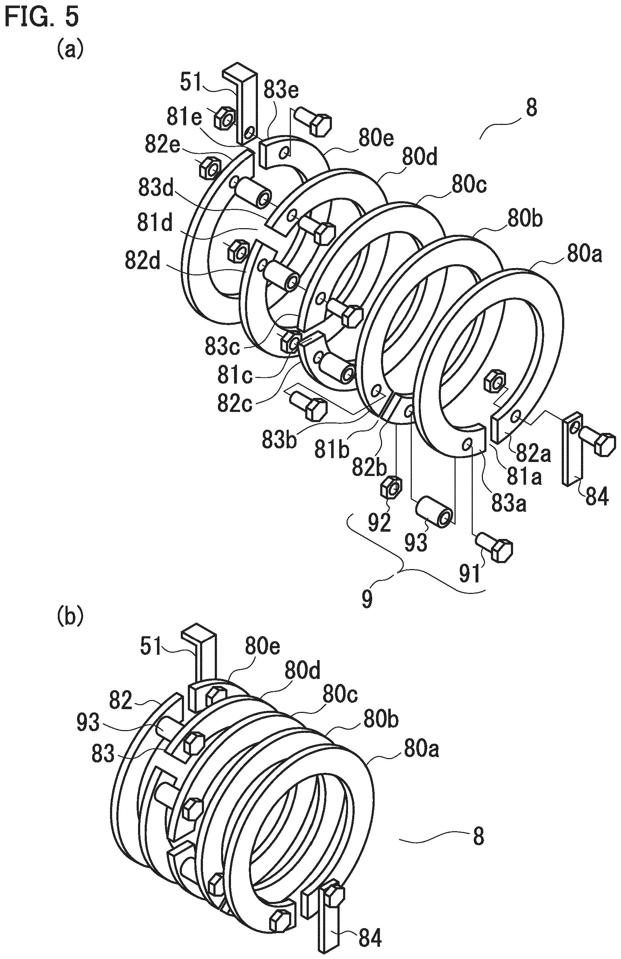

Details will be described. Figs. 5 show the magnetic field generator of the present embodiment. Fig. 5(a) is an exploded perspective view and Fig. 5(b) is a perspective view of the entire magnetic field generator. As shown in these drawings, individual electrically conductive plate members 80a-80e constituting a magnetic field generator 8 (the drawings show 5 plates but any number can be selected) have a roughly horse-shoe shape in which part of a ring is notched (expressed also as a C-shape), and two ends 82a-82e, 83a-83e are respectively formed on both sides of each notch 81a-81e. All of the plate members 80a-80e having the same shape are arranged in parallel to each other and each adjacent two of the plate members 80a-80e are electrically connected. Examples of an electrically conductive material of the plate members include stainless steel, copper, copper alloys, aluminum, aluminum alloys, and graphite.

Positions of the notches 81a-81e of the parallel plate members 80a-80e are sequentially varied by a predetermined angle between each adjacent two of the plate members 80a-80e. This angle adjustment changes positions of the ends 82a-82e, 83a-83e on both sides of the notches 81a-81e. For example, in a relation between a first plate member 80a and a second plate member 80b, one end 82b of the second plate member 80b faces the other end 83a of the first plate member 80a. The two ends 83a, 82b on facing different sides are combined by a fastening member 9, whereby the adjacent two plate members 80a, 80b can be electrically connected to each other. The fastening member 9 comprises not only a typical bolt 91 and a typical nut 92 but also a tubular electrically conductive part 93 formed of an electrically conductive material. When the electrically conductive part 93 is arranged between the adjacent two plate members 80a, 80b, the electrically conductive part 93 electrically connects the adjacent two plate members 80a, 80b, while keeping an appropriate distance between them.

Upon thus combined by fastening members 9 as shown in Fig. 5(b), all the plate members 80a-80e as a whole form a roughly tubular magnetic field generator 8. A plasma flow can flow inside (through a central hole of) the roughly annular magnetic field generator 8. At this time, an electric current flows in the same direction as a circumferential direction of the respective plate members 80a-80e, and sequentially moves from one to a subsequent one of the plate members 80a-80e by way of facing adjacent two kinds of ends 82a-82e, 83a-83e, making a roughly spiral shape. When an electric current flows in the roughly spiral shape, the plate members 80a-80e can generate a magnetic field just like an electromagnetic coil, and can guide a plasma flow in a direction along a central axis of the magnetic field generator 8. Note that a reference sign 51 designates a connector to the protection member and a reference sign 84 designates a connector to a positive electrode side of the arc power source.

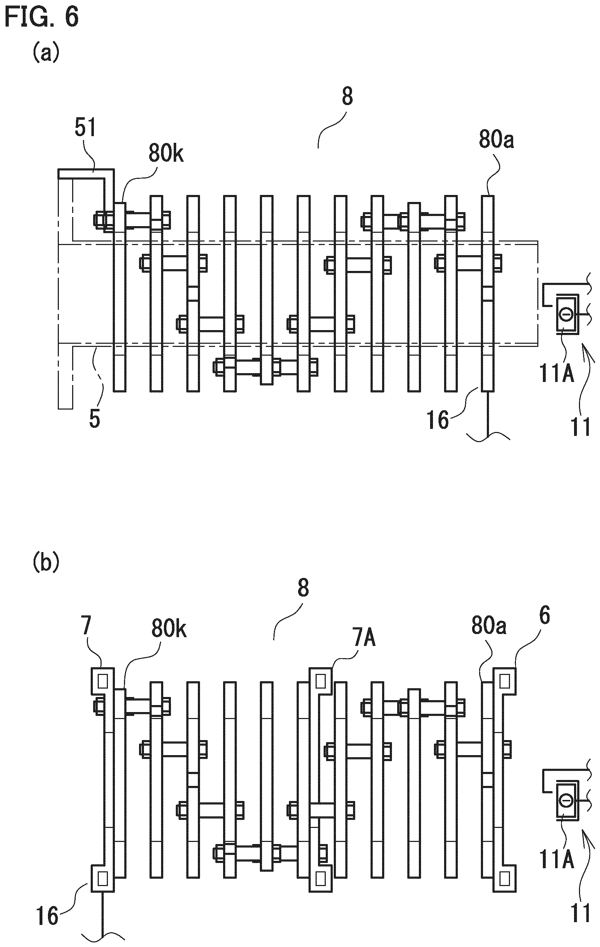

When the magnetic field generator 8 having the above structure is used, as shown in Figs. 6, the magnetic field generator 8 can be protected by the aforementioned protection member 5 (see Fig. 6(a)) or the annular protection member 6 (see Fig. 6(b)). Note that in Figs. 6, the number of plate members are increased to 80a-80k in order to show a shape of the magnetic field generator 8 and dimensional ratios of component parts are not considered.

When the protection member 5 is employed as shown in Fig. 6(a), a connector 51 for connection to the protection member 5 is connected to a plate member 80k on one end, and a plate member 80a on the other end is connected to a positive electrode of an arc power source.

When an annular protection member 6 such as that of the second embodiment is used as shown in Fig.6(b), the protection member 6 should be arranged on a cathode part side. A similar member (a distal end annular member) 7, and another similar member (an intermediate annular member) 7A can be respectively provided at a distal end (an opposite side to the cathode part) and an intermediate position of the magnetic field generator 8. When this type of annular members 6, 7, and 7A are arranged, the annular members 6, 7, and 7A can have hollow annular inner parts and allow cooling water to be introduced into the hollow annular inner parts. In this case, protection of the magnetic field generator 8 from evaporated particles and droplets by the annular protection member 6 is effected by a surface of the annular protection member 6, but it is easily predicted that some evaporated particles and droplets which have passed through the protection member 6 are also attached to the plate members 80a-80k. Any of the plate members 80a-80k can be provided with a cooling mechanism.

However, even when the evaporated particles and the droplets are attached to the plate members 80a-80k, these plate members 80a-80k are integrated by the fastening members 9 (see Figs.5), the plate members 80a-80k can be easily separated by releasing the fastening members 9, and an operation to remove (or clean) attached materials from the separated individual plate members 80a-80k can be easily conducted. The removing operation can be done mechanically, for example, by lathing or shot blasting. Chemical removal using chemical agents is also easy. It should be noted that once removed from the magnetic field generator 8, the tubular protection member 5 shown in Fig. 6(a) can be easily cleaned of the attached materials. Since each component part is small, the each component part can also be easily subjected to ultrasonic cleaning.

### [Fourth Embodiment]

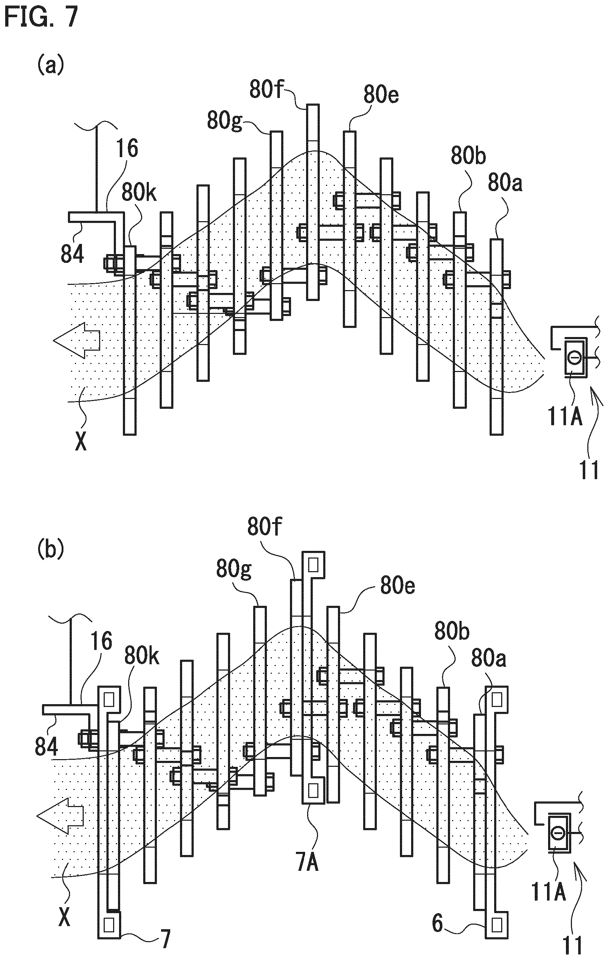

A fourth embodiment uses roughly horse-shoe-shaped plate members 80a-80k such as mentioned above, and sequentially displaces positions of the plate members 80a-80k in a radial direction of a central hole. The displaced states are shown in Figs. 7.

As shown in Fig. 7(a), all of the individual plate members 80a-80k have the same roughly horse-shoe shape, and similarly to the third embodiment, each adjacent two of the plate members 80a-80k are electrically connected by fastening members 9. Therefore, the plate member 80a-80k as a whole can pass an electric current in a roughly spiral shape. In addition to this, the individual plate members 80a-80k are sequentially displaced in a radial direction.

When 11 sheets of plate members 80a-80k, for instance, are used as shown in Fig. 7(a), a subsequent plate member 80b is radially elevated with respect to a first plate member 80a, and such displacement is repeated. A sixth plate member 80f in a middle is located at a highest position and then a seventh plate member 80g to a last plate member 80k are sequentially lowered. When height of the individual plate members 80a-80k are thus changed, a central hole of a magnetic field generator 8 meanders and as a result, a transport route of evaporated particles can be regarded to meander. In this case, when height of the first plate member 80a is aligned with that of the last plate member 80k, input and output positions of the transport route of the evaporated particles are the same as those inside the plate members 80a-80k which are all aligned in straight line.

By thus winding a central hole of a magnetic field generator 8 through which an electric current flows in a roughly spiral shape, a generated magnetic field makes a flow of arc plasma X (plasma flow) meander. In contrast to this, neutral particles and droplets move straight, and therefore the neutral particles and the droplets emitted from the cathode 11A collide with surfaces of the individual plate members 80a-80k. When the plate members 80a-80k are formed of a material to which droplets are attachable, droplets are attached to the surfaces of the plate members 80a-80k. When the plate members 80a-80k are formed of a material which bounces back (or reflects) droplets, the droplets are bounced back by the surfaces of the plate members 80a-80k and cannot move forward toward an object to be treated.

Besides, the first plate member 80a receives collision of a greatest number of neutral particles and droplets, and neutral particles and droplets which have passed through the first plate member 80a collide with the second plate member 80b. Therefore, collision of the droplets is concentrated on part of the plate members 80a-80f on a first half of the entire magnetic field generator 8. Especially when a center hole of a plate member 80f in a middle position does not overlap that of the first plate member 80a due to individual displacement conditions, neutral particles and droplets do not reach a second half, i.e., the plate members 80g-80k. Therefore, in the present embodiment, without providing any special protection member for protecting the magnetic field generator 8, part of the magnetic field generator 8 (the first half 80a-80f) can protect other parts of the magnetic field generator 8 (the second half 80g-80k). Accordingly, attached neutral particles and droplets can be collected by regularly replacing the first half 80a-80f of the plate members with new ones.

Although the aforementioned structure shown in Fig. 7(a) does not employ a protection member apart from the magnetic field generator 8, part of the magnetic field generator 8 (the plate members 80a-80f arranged on the cathode side) serves as a protection member (substitutes a protection member). It should be noted that in this structure, the first plate member 80a can serve as an anode. In this case, when a connector 84 to an arc power source is provided at the last plate member 80k, the magnetic field generator 8 can generate a magnetic field by a self current (an electron current) of an arc discharge.

Moreover, in order to cool an anode, an annular protection member 6 can be arranged on the cathode side, as shown in Fig. 7(b). In this case, annular members with the same structure (a distal end annular member and a middle annular member) 7 and 7A can be additionally arranged at a distal end (an opposite side to a cathode part side) and at a middle position. Then cooling water can be introduced to their hollow annular inner parts. Since temperature remarkably increases at a bent part of a plasma flow, it is especially preferable to provide water-cooling annular members at these three bent parts (see Fig. 7(b)).

According to the present embodiment, the magnetic field generator 8 is used as an anode part, and at the same time, part of the magnetic field generator 8 serves as a protection member. Moreover, a magnetic field generated by the magnetic field generator 8 makes a plasma flow meander. However, since an extra distance necessary for meandering is very small, a distance from the cathode part 11 to an object to be treated can be decreased eventually. This achieves reduction of a decrease in density of evaporated materials formed by an arc discharge and an improvement in film-forming rate.

### [Experiment]

An experiment was conducted for inspecting a film condition formed by using a magnetic field generator using such horse-shoe-shaped plate members as shown in Fig. 7(a). Experimental conditions were as follows. A cathode material was titanium (Ti) and serving as an anode were 15 sheets of horse-shoe-shaped plate members formed of oxygen-free copper. The plate members had inner diameters within the range of 100 mm to 150 mm changing gradually from 100 mm around a center to 150 mm at both ends. The whole of the horse-shoe-shape magnetic field generator had a magnetic flux density of about 6 mT. An arc current was 110 A. An atmosphere gas was N₂, which was introduced at a flow rate of 30 sccm. A chamber internal pressure (a film-forming pressure) was 0.3 Pa and thickness of a film to be formed was adjusted to about 1.8 µm. A distance between a cathode part and an object to be treated in a film-forming device was about 350 mm.

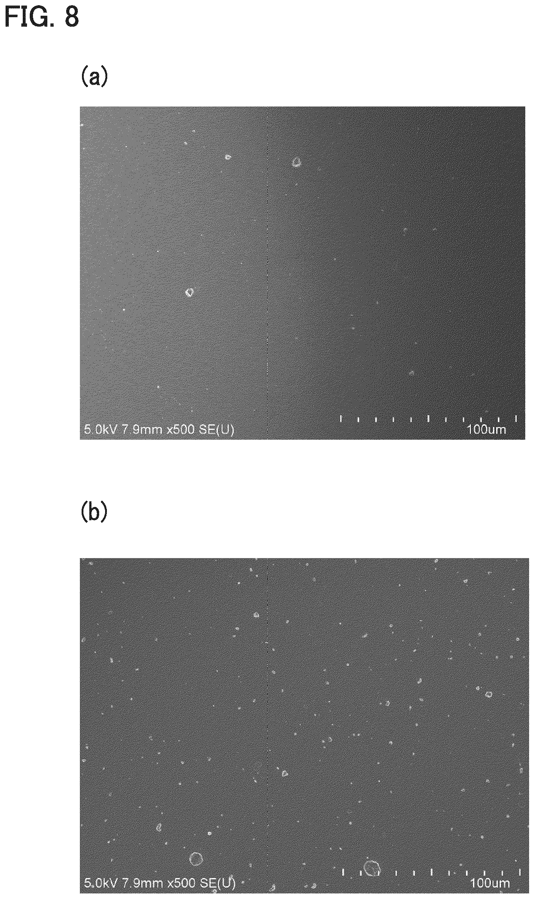

A surface of a TiN film formed under the above conditions was observed using a scanning electron microscope. Its result is shown in Fig. 8(a). For comparison, a film of the same thickness was formed by using a tubular anode which did not generate a magnetic field and a surface of the film was also observed using the scanning electron microscope. Its result is shown in Fig. 8(b). A comparison of these SEM images in Figs. 8(a), and 8(b) clearly shows that attachment of droplets onto surfaces of films having the same film thickness is remarkably different between these two.

### [Modifications]

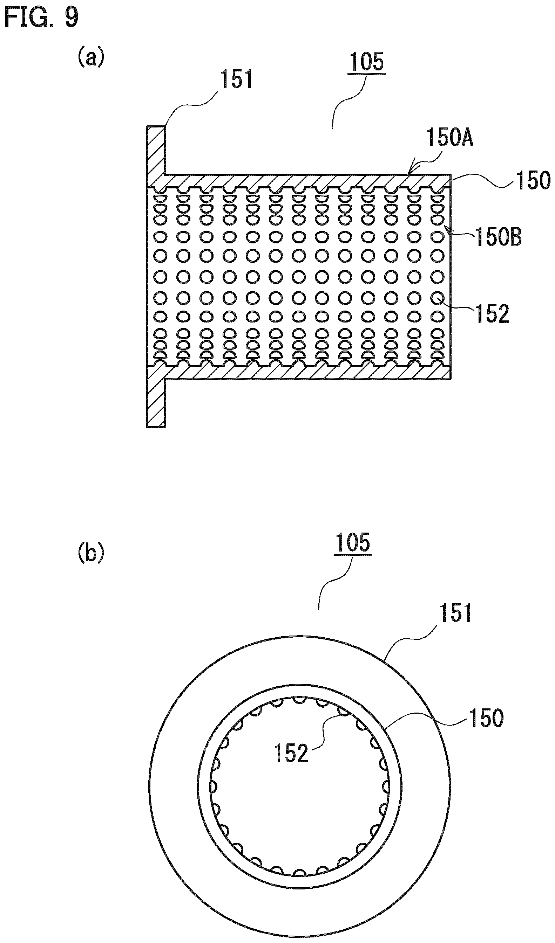

Next, modifications of the first embodiments will be explained. Figs. 9 show a modification of the protection member 5 in the first embodiment. Fig. 9(a) is its longitudinal cross-sectional view and Fig. 9(b) is its side view. In this modification shown in these drawings, a plurality of projections 152 are formed on an inner surface 150B of a tubular main body 150 of a protection member 105 and thus make the inner surface 150B uneven. Uneven means that the inner surface 150B clearly become bumpy by providing the projections 152 when compared to an outer surface 150A.

When graphite or the like is used as a cathode material just like in forming a DLC film, this protection member 105 is used to bounce back (or reflect) droplets emitted from a cathode without attached on a surface thereof. That is to say, when the inner surface 150B is even and smooth, it is predicted that droplets which have collided with the surface are reflected and move toward an object to be treated. However, when the inner surface 150B has a plurality of projections 152, there is a very high possibility that droplets collide with any of the projections 152. As a result, reflection angle of droplets which have collided with any of the projections 152 is greatly changed, so a ratio of droplets moving toward the object to be treated can be decreased. When droplets collide with any of the projections 152, collision with part of a surface on a cathode side is common and the droplets are supposed to be reflected backward.

The inner surface 150B can be made uneven by forming dents in place of these projections 152. Moreover, the protection member 105 can be provided with an outwardly extending part (a flange part) at one end of the main body 150 and the outwardly extending part can be used as a connector 151 to a magnetic field generator (an electromagnetic coil, etc.) surrounding the outer periphery of the main body 150. Moreover, this outwardly extending part (the flange part) can be increased in ring thickness and have a hollow annular inner part for permitting cooling water to be introduced.

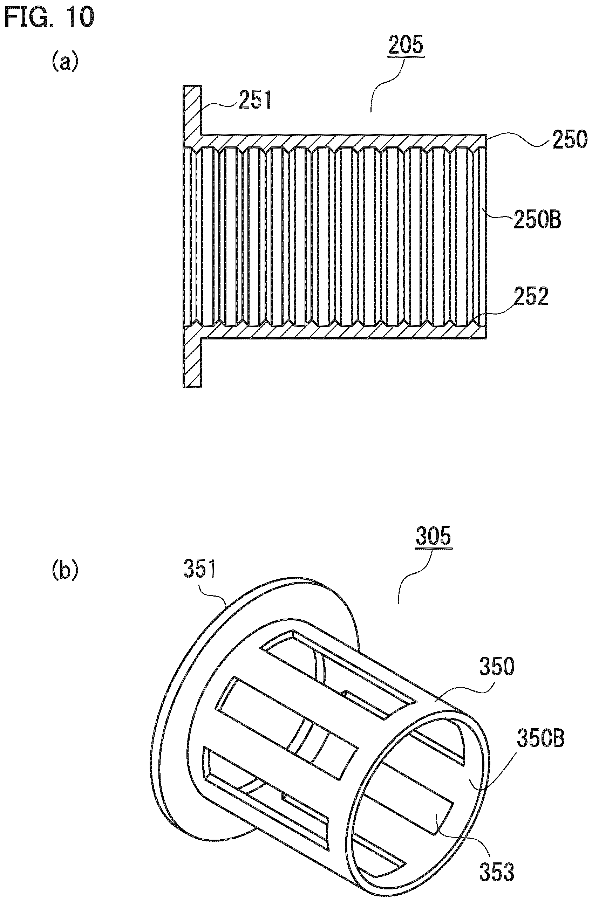

Another modification is a protection member 205 having a structure shown in Fig. 10(a). In this modification, projections 252 on an inner surface 250B of a main body 250 have an annular shape. This structure, too, can change directions to reflect droplets which have collided with the inner surface 250B. The annular projections shown in Fig. 10(a) can be replaced with spiral projections. Besides, the annular projections can be replaced with annular grooves. A flange part 251 can have the same structure as that of the above modification.

A still another modification is a protection member 305 having a structure shown in Fig. 10(b). In this modification, a main body 350 has a plurality of through holes 353. Although these through holes 353 are formed long in a generating line direction of the tubular main body 350, these through holes can be short and have a circular or other shapes. Here, the long through holes 353 are shown as an example. When this type of through holes 353 are formed, droplets to collide with an inner surface 350B of the protection member main body 350 pass through the inner surface 350B without collision and, as a result, are not reflected by the inner surface 350B. Therefore, the droplets are avoided from moving toward an object to be treated.

As a matter of course, some droplets are assumed to collide with and be reflected by part of the inner surface 350B except the through holes 353, but an increase in ratio of a penetration area occupied by the through holes 353 leads to a decrease in reflection ratio. Besides, this inner surface 350B can be separately provided with the aforementioned projections 152.

Similarly to the above modifications, a flange 351 in this modification can also be used as a connector to an electromagnetic coil, etc. or can have a hollow annular inner part which permits cooling water to be introduced.

### [Conclusions]

As described in the above embodiments and modifications, the magnetic field generators 21 and 8 for guiding a plasma flow generates a magnetic field by an electric current of an arc discharge generated by plasma generating means. Therefore, a structure from the cathode part 11 to the film-forming chamber 3 can be reduced in size and distance when compared to a structure in which the magnetic field generator and plasma generating means are separately provided. In such a small distance, the droplets are attached to the protection member 5, 6 and/or the distal end annular member 7, or directions to bounce back the droplets are controlled by a surface of the protection member 5, 105, 205, or 305. Thus, at least droplets can be suppressed from reaching the film-forming chamber 3.

Although the embodiments and modifications of the present invention have been described above, these embodiments and modifications are only examples of the present invention and the present invention is not limited to these embodiments and modifications. Therefore, elements of the above embodiments and modifications can be modified and another element can be added.

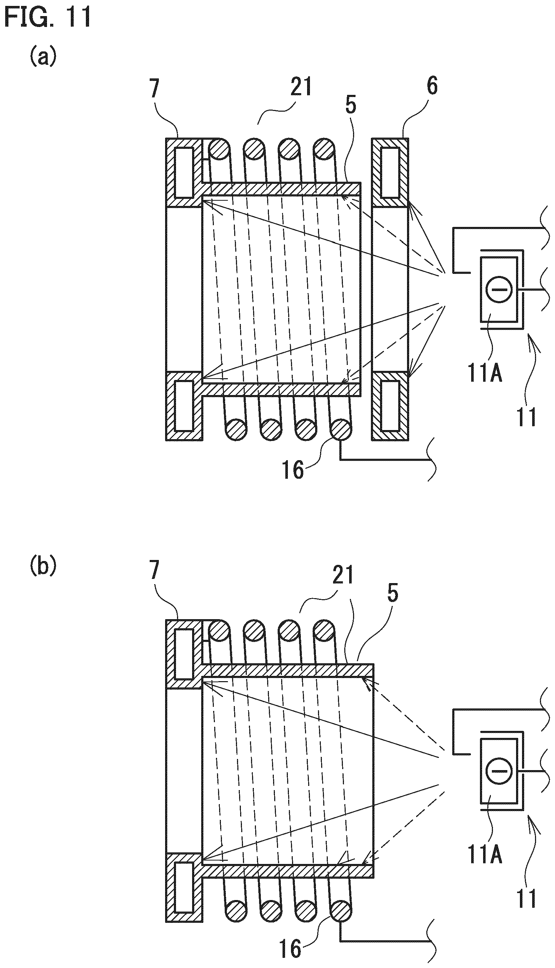

For example, when a tubular protection member 5, and an annular protection member 6 and/or a distal end annular member 7 are used, modifications shown in Figs. 11 are possible. Figs. 11 are longitudinal cross-sectional views. As shown in the drawings, the annular protection member 6 and the distal end annular member 7 can have smaller inner diameters than the tubular protection member 5, thereby decreasing a ratio of droplets attached to an inner surface of the tubular protection member 5. With such a structure, collision of droplets, etc. with the tubular protection member 5 can be decreased (Fig. 11(a)) and droplets which have passed the tubular protection member 5 and move toward an object to be treated can be further decreased (Figs. 11(a), 11(b)). Inner surfaces of these tubular protection members 5 can have projections 152 and 252 as in the aforementioned modifications. It should be noted that when the annular protection member 6 is used as shown in Fig. 11(a) but does not serve as an anode (or a power source connector 16), the annular protection member 6 is not electrically connected to the tubular protection member 5 or the electromagnetic coil 21. Specifically, the annular protection member 6 is separated from the tubular protection member 5 or the tubular electromagnetic coil 21, or is insulated. When the protection member 6 is formed of an electrically non-conductive material, the tubular protection member 5 and the annular protection member 6 can be physically connected to each other.

Since these protection members are easily removable from the anode part and have a simple structure as a whole when compared to a coiled structure, vapor deposits can be easily removed. For example, the vapor deposits can be mechanically removed by lathing or shot blasting. The vapor deposits can also be easily removed by chemicals. Of course, when these protection members are used without removing the vapor deposits, shapes of the coiled structures shown in Figs. 3 and 4 can be bent as shown in Figs. 7.

Furthermore, when an electrically insulating film is to be formed, an anode screen can be provided between an anode and plasma. Since a structure of the anode screen is described in detail in Japanese Unexamined Patent Application Publication No. H05-247630, drawings are omitted here. In this case, the anode screen has a great number of small-diameter holes. When the anode screen is thus provided, most of an electrically insulating film material in forming a film is deposited on the anode screen and only a small part leaked out from the small-diameter holes of the anode screen is deposited on the anode. At this time, the electrically insulating film material is not deposited on part of the anode shaded by the anode screen except the small-diameter holes, and thus the anode is avoided from covered with the electrically insulating film material. Note that even when the anode screen is provided, an arc current (an electron current of a vacuum arc discharge) can flow to the anode through the small-diameter holes, so a path of the arc current can be secured with stability. An example of this type of anode screen is a punching metal formed of stainless steel, but others can be used. When the anode screen is formed of an electrically conductive material and serves as part of an anode until an electrically insulating film material is deposited, the anode screen is electrically connected to the anode having the aforementioned structure.

### Reference Signs List

1 Plasma generating means
2 Plasma duct
3 Film-forming chamber
4 Insulated feed-through terminal
5, 6, 7, 105, 205, 305 Protection members
8 Magnetic field generator
9 Fastening member
11 Cathode part
11A Cathode
12 Anode part
13 Arc power source
14 Trigger electrode
15 Arc-stabilizing magnetic field generator
16 Power source connector
21 Electromagnetic coil
51, 52 Connectors
61, 71 Hollow inner part of an annular part of a protection member (a hollow annular inner part)
80a, 80b, 80c, 80d, 80e, 80f, 80g, 80k Plate members
81a, 81b, 81c, 81d, 81e Notches
82a, 82b, 82c, 82d, 82e One end of each plate member
83a, 83b, 83c, 83d, 83e The other end of each plate member
84 Connector
91 Bolt
92 Nut
93 Electrically conductive part
150, 250, 350 Tubular main body of a protection member
150A Outer surface of a main body of a protection member
150B, 250B, 350B Inner surface of a main body of a protection member
151, 251, 351 Flange part (connector)
152 Projections
252 Projections (annular)
353 Through holes
X Arc plasma

## Claims

1. A film-forming device, comprising plasma generating means for generating plasma by an arc discharge in vacuum between a cathode and an anode electrically connected to each other by way of a power source, and vaporizing a cathode material constituting the cathode and forming a film by vapor deposition on a surface of an object to be treated,
the plasma generating means comprising:
a cathode part;
an anode part arranged at an appropriate distance from the cathode part;
a magnetic field generator constituted by the anode part or constituted integrally with or continuously from the anode part and generating a magnetic field by a self current of the arc discharge; and
a protection member constituted by part of the anode part, or constituted independently from the anode part while electrically connected to the anode part, or substituted by part of the magnetic field generator, and arranged between the magnetic field generator and the plasma to protect part or a whole of the magnetic field generator from the cathode material.

2. The film-forming device according to claim 1, wherein the magnetic field generator is arranged in a roughly tubular shape surrounding a plasma flow region, and
the protection member is a water-cooling ring member arranged at at least one of ends on a cathode side or its opposite side of the roughly tubular magnetic field generator, and having a surface with an appropriate area in a radial direction of the magnetic field generator and having a hollow inner part for introducing cooling water.

3. The film-forming device according to claim 1, wherein the magnetic field generator is formed in a roughly tubular shape surrounding a plasma flow region, and
the protection member is a tubular member arranged between the plasma flow region and the magnetic field generator.

4. The film-forming device according to claim 3, wherein the protection member has a plurality of through holes.

5. The film-forming device according to claim 3, wherein at least an inner surface of the protection member is uneven.

6. The film-forming device according to claim 5, wherein the inner surface of the protection member has a shape selected from the group consisting of a large number of standing parts formed by making a plurality of partial cuts in the protection member and bending parts of the protection member to stand, a large number of through holes formed by perforating appropriate parts of the protection member, a plurality of dents formed by denting the inner surface for an appropriate interval, a large number of projections formed by projecting the inner surface for an appropriate interval, and a plurality of annular projections continuously projecting in a circumferential direction of the roughly tubular shape.

7. The film-forming device according to any one of claims 1 to 6, wherein the magnetic field generator is a coiled magnetic field generator constituted by a continuously and spirally 8winding conductive material or a continuously and spirally winding hollow conductive material.

8. The film-forming device according to any one of claims 1 to 6, wherein the magnetic field generator comprises a plurality of electrically conductive plate members arranged at appropriate intervals, and each of the plate members has a roughly horse-shoe shape in which part of a ring has a notch, and an end on one side of a notch of any one of the plate members is electrically connected with an end on the other side of a notch of an adjacent one to the one of the plate member so that an electric current of an arc discharge flows sequentially between each adjacent two of the plate members in a manner to flow in a roughly spiral shape.

9. The film-forming device according to claim 8, wherein the plate members are arranged so that center positions of the roughly horse-shoe shapes are sequentially displaced in angular direction with respect to a plasma flow direction, thereby making the central holes of the magnetic field generator meander.

10. The film-forming device according to claim 9, wherein the magnetic field generator has a water-cooling ring member in a hollow annular shape at a given position from a starting end side to a finishing end side of the plate members.

11. The film-forming device according to any one of claims 1 to 10, wherein the magnetic field generator generates a magnetic field having a magnetic flux density within the range of 0.01 to 20 mT.
